# EUROPEAN PATENT APPLICATION

(11) **EP 3 648 119 A1**
(43) Date of publication of application: **06.05.2020**
(21) Application number: 19206545.6
(22) Date of filing: 31.10.2019
(51) Int. Cl.: H01B 7/282, H01B 7/08, H01B 7/29, H05K 1/00

(54) **VEHICULAR ELECTRICAL DEVICE**

(30) Priority: 02.11.2018 KR 20180133581
(71) Applicant: Jin Young Global Co., Ltd., Gyeongsangbuk-do (KR)
(72) Inventor: KIM, Dong Sik, Gyeongsangbuk-do (KR); KIM, Kyong Do, Gyeongsangbuk-do (KR)
(74) Representative: dompatent von Kreisler Selting Werner - Partnerschaft von Patent- und Rechtsanwälten mbB

(57) **Abstract**

The present invention is related to a patterning formation method of a printing method formed on a film base, a manufacturing method of an electrical device using the same, and a vehicular electrical device. A patterning formation method of a printing method is provided formed on a film base for forming a metal layer, an insulating layer or a semiconductor layer on an upper surface of a PCT film using the PCT film as a base by any one printing method selected from inkjet, screen printing and gravure, and using this. A manufacturing method of an electrical device for manufacturing an electrical device which replaces a conventional FPCB, and a vehicular electrical device which can used in various forms are provided.

According to the present invention, it is possible to prevent the generation of oligomers by moisture absorption by using a structure which includes forming a printed electronic circuit and including a PCT film on at least one side, prevent the phenomenon whereby a film tears or peels off under high temperature and high humidity conditions, and ensure long-term reliability. In particular, it is possible to slim the device while ensuring long-term reliability by replacing various vehicular electrical devices which have been conventionally used, and reduce processes and manufacturing time and reduce costs.

## Description

### [TECHNICAL FIELD]

The present invention is related to a patterning formation method of a printing method formed on a film base, a manufacturing method of an electrical device using the same, and a vehicular electrical device. More particularly, the present invention is related to a patterning formation method of a printing method formed on a film base including arranging a PCT (Poly Cyclohexylene dimethylene Terephthalate) film as a base film or an upper part film (coverlay film), and patterning a material such as metal by a printing method or connecting printing electronic technologies on at least a part of the PCT film, a manufacturing method of an electrical device using the same and a vehicular electrical device.

### [BACKGROUND ART]

Generally, electrical devices such as a wired harness, FFC (Flexible Flat Cable), FPC (Flexible Printed Circuit) and coaxial cables and the like are used as interfaces for electrically connecting various electronic devices, such as an electronic circuit board and the like.

The Wired harness is formed by enclosing a conductive wire with an insulation coating. The conductive wire is connected to a connector terminal by pressure bonding or a crimping method, and the male connector assembly formed by the pressure bonding or a crimping method is connected to the Printed Circuit Board (PCB) through the connection with the female connector assembly by soldering method or assembly method.

The FFC (Flexible Flat Cable) forms an adhesive on an insulating film, and is formed to extend and wrap the conductor wire in the longitudinal direction on the adhesive.

The FPC (Flexible Printed Cable) is formed by a method in which a PI (Poly Imide) film or a PEN (Poly Ethylene Napthalene) film is used as a base film. A copper conductor is formed into a thin film on the base film. The copper conductor is etched according to the circuit configuration, and then the PI film or PEN film is laminated to an upper part of the copper conductor as an upper part film.

On the other hand, printing electronics technology is coming to the forefront as a technology which can replace an exposure process which requires expensive materials, complex etching processes and expensive equipment. This technology allows printing circuits on electronic circuit boards compared to conventional etching methods, and directly forming pattern with a desired substance at a desired position without involving complicated processes.

In the case when applying this printing electronic technology does not require the chemical substances used in the conventional etching processes. As such, the printing electronic technology brings cleaner process and reduced cost, and increases competitiveness by reducing the number of processes and amount of materials required in conventional exposure process for metal etching.

Usually, printing electronic technology is a technology for patterning on a film substrate by a printing method, and a PET (Poly Ethylene etherate), PI (Polyimide) film are mainly used as a base film and an upper part film (coverlay) when producing conventional interface products.

Although PET and PI films are considered as stable, when long-term using or processing, especially uses under higher temperature or high humidity conditions, tearing and peeling often occur at the surface of the PET and PI films. This is due to the formation of oligomers in the film under the high temperature or the high humidity conditions.

In addition, PET and PI films have a problem whereby the insulating properties deteriorate due to moisture (H₂O) flowing in from the exterior.

Due to the characteristics of this type of PET film, in the case when a product or process to which a printing electronic technology is applied, product defects occur when exposed for a long time under a condition of high temperature and high humidity, and the product to which the printing electronic technology is applied has the disadvantage whereby it has technical limitations such as a difficulty in guaranteeing long-term reliability.

### [CITATION LIST]

### [PATENT LITERATURE]

[Patent Document 1]
   Korean Published Patent Application No.10-2014-0096039
[Patent Document 2]
   Korean Registered Patent No.10-1501449

### [SUMMARY OF INVENTION]

### [TECHNICAL PROBLEM]

One embodiment of the present invention has been devised considering overcoming the conventional problems described above and a PCT film (Poly Cyclohexylene dimethylene terephthalate) which has strong characteristics in a high temperature and high humidity environment. The PCT film has physical properties such as high heat resistance invariable by moisture under a condition of high temperature and high humidity than that of a PET film. By forming a pattern with a printing method on the PCT film, the problem of long-term reliability under high temperature and high humidity conditions in a product which is applied with a printing electronic technology on a conventional PET film is improved. According to these embodiments of the present invention, the instant specification is directed to a patterning formation method including printing a film base, a manufacturing method of an electrical device using the same, and a vehicular electrical device which exhibits long term stability under high temperature and high humidity conditions.

In some embodiments of the present invention, the instant specification is directed to use a PCT (Poly Cyclohexylene dimethylene terephthalate) film which is resistant to high temperature and high humidity environments as a base film or an upper film (coverlay film), and by combining this with printing electronic technology, it is possible to prevent the phenomenon whereby a film is torn or peeled off which occurred in a conventional example due to the generation of oligomers under high temperature and high humidity conditions. According to these embodiments of the present invention, the instant specification is directed to a patterning formation method including printing a film base, a manufacturing method of an electrical device using the same, and a vehicular electrical device.

In some embodiments of the present invention, the instant specification is directed to a patterning formation method of a printing method formed on a film base, a manufacturing of method an electrical device using the same and a vehicular electrical device which can replace and slim a vehicular electrical device so that it is possible to reduce processes, manufacturing time and costs, and increase product reliability.

In some embodiments of the present invention, the instant specification is directed to a patterning formation method including printing a pattern on a film base material, a manufacturing method of an electrical device using the same, and a vehicular electrical device manufactured using the electronic printing technologies.

### [MEANS FOR SOLVING THE PROBLEMS]

A vehicular electrical device according to one embodiment of the present invention for achieving the aims described above is a vehicular electrical device for use as a vehicular LED module includes a heat sink, and a metal layer formed on an upper side of the heat sink by any one printing method selected from inkjet, screen printing and gravure.

The vehicular electrical device may include an insulating layer formed so as to cover the metal layer.

The insulating layer may be made of a PCT (Poly Cyclohexylene dimethylene terephthalate) material.

According to another embodiment of the present invention, a vehicular electrical device for use as a vehicular touch module includes a printing type touch film having a connector connection part, a PCT film arranged on one surface of an upper part or lower part of the printing type touch film, a touch recognition part formed in a mesh type pattern on the PCT film and formed using a metal material by any one printing method selected from inkjet, screen printing and gravure printing methods, a touch outline part connected to the touch recognition part and formed at an edge part of the touch recognition part by a metal printing method, a carbon printing part formed by being electrically connected to the touch outline part, and an optical double-sided tape arranged on one side of the PCT film, wherein the optical double-sided tape is formed by an autoclave or UV processing method so as to be adhered to an injection object.

The touch recognition part formed in the mesh type pattern may be formed having a line width of 40 µm or less.

The touch recognition part may be formed by performing an offset method etching process in order to form the mesh pattern of the touch recognition part having a line width of 40 µm or less.

According to another embodiment of the present invention, a vehicular electrical device for use as a vehicular touch module includes a PCT film, an ITO layer formed from an ITO material on an upper surface of the PCT film by any one printing method selected from inkjet, screen printing and gravure, a printing layer formed on an upper surface of the ITO layer by any one printing method selected from inkjet, screen printing and gravure, an optical double-sided tape adhered to an upper surface of the printing layer, and an adhesive tool adhered through the optical double-sided tape as a medium.

According to another embodiment of the present invention, a vehicular electrical device for use as a vehicular bus bar cable includes an FFC (Flexible Flat Cable) type bus bar body formed from a PCT film, an FFC wire existing within the bus bar body, and a metal terminal arranged to be exposed at both ends of the bus bar body and being connected to the FFC wire.

The bus bar body may be formed from a multi-layer in which two or more PCT films having a constant length and width are stacked, and each layer is bonded by an adhesive layer.

A metal plate having a rivet hole on a side where the FFC wire may be exposed, the metal plate being joined on the bus bar body formed from a multi-layer including two or more PCT films, wherein the metal plate is connected to another cable by bolting to the rivet hole side.

The FFC wire has a wire thickness of 30 µm to 100 µm.

According to another embodiment of the present invention, a vehicular electrical device for use as a vehicular bus bar cable includes an FFC (Flexible Flat Cable) type bus bar body formed from a PCT film, and a metal printing layer formed on an upper part of the FFC type bus bar body, wherein the metal printing layer has a function of any one of a passive element, an active element, a fuse element and a semiconductor element.

According to another embodiment of the present invention, a vehicular electrical device for use as a vehicular hybrid flexible cable includes a PCT film, a metal ink printing line formed in a line shape in a longitudinal direction, located on one surface of the PCT film and formed by printing a metal material by any one printing method selected from inkjet, screen printing and gravure, and an FFC wire line formed in a line shape in a longitudinal direction, located on another surface of the PCT film and including an FCC wire.

The vehicular electrical device may include a crosstalk prevention space for preventing signal crosstalk between the metal ink printing line and the FFC wire line arranged between the metal ink printing line and the FFC wire line, wherein the metal ink printing line and the FFC wire line are formed so as to be positioned on both sides of the crosstalk prevention space.

The vehicular electrical device may include a crosstalk prevention dummy line for preventing signal crosstalk between the metal ink printing line and the FFC wire line arranged between the metal ink printing line and the FFC wire line.

The crosstalk prevention dummy line may be formed by any one group of printing methods selected from inkjet, screen printing, and gravure.

The crosstalk prevention dummy line may be a metal layer or a semiconductor layer.

In addition, a manufacturing method of a vehicular electrical device according to one embodiment of the present invention for achieving the aims described above includes forming a pattern layer on an upper surface of a PCT film used as a base film by printing a metal material or a semiconductor material by any one printing method selected from inkjet, screen printing, and gravure, adhering a coverlay film to the upper surface of the pattern layer, and integrally bonding the base film, the pattern layer and the coverlay film with an adhesive layer including a thermosetting adhesive as a medium.

According to another embodiment of the present invention, a manufacturing method of a vehicular electrical device includes forming a pattern layer on an upper surface of a PCT film used as a base film by printing a metal material or a semiconductor material by any one printing method selected from inkjet, screen printing, and gravure, adhering a coverlay film to the upper surface of the pattern layer by integrally bonding the base film, the pattern layer and the coverlay film with an adhesive layer including a thermoplastic adhesive as a medium.

According to another embodiment of the present invention, a manufacturing method of an electrical device includes (A) a step of arranging any one film selected from a PI film, a PEN film and a PCT film as a base film, (B) a step of forming a pattern layer on an upper surface of the base film by printing a metal material or a semiconductor material by any one printing method selected from inkjet, screen printing and gravure, (C) a step of arranging and bonding together a PCT film as a coverlay film so as to cover the pattern layer, (D) a step of forming a silk printing layer on the upper surface of the PCT film bonded as the coverlay film by a silk printing method, (E) a step of forming an outline shape by processing an outline with a mold or laser processing on the resultant product after the step (D), and (F) a step of bonding an aluminum plate for a heat releasing function to a lower part of the resultant product after the step (E).

In addition, a patterning formation method of a printing method formed on a film base according to one embodiment of the present invention for achieving the aims described above includes forming a metal layer on an upper surface of a PCT film used as a base film by printing a metal material by any one printing method selected from inkjet, screen printing and gravure.

According to another embodiment of the present invention, a patterning formation method of a printing method formed on a film base includes forming an insulation layer on an upper surface of a PCT film used as a base film by printing an insulating material by any one printing method selected from inkjet, screen printing and gravure.

According to another embodiment of the present invention, a patterning formation method of a printing method formed on a film base includes forming a semiconductor layer (active layer) on an upper surface of a PCT film used as a base film by printing a semiconductor material by any one printing method selected from inkjet, screen printing and gravure.

According to another embodiment of the present invention, a patterning formation method of a printing method formed on a film base includes arranging a PI (Poly Imide) film or a PEN (Poly Ethylene Napthalene) film as a base film on a lower part, arranging a PCT film as a coverlay film on an upper part, and forming a silk printing layer on an upper surface of the PCT film by a silk printing method so as to use the silk printing layer in the arrangement of electronic components.

According to another embodiment of the present invention, a patterning formation method of a printing method formed on a film base includes arranging a PCT film as a base film on a lower part, arranging a PCT film as a coverlay film on an upper part, and forming a silk printing layer on an upper surface of the PCT film used as the coverlay film by a silk printing method so as to use the silk printing layer in the arrangement of electronic components.

The patterning formation method of the printing method formed on the film base may form a metal layer on the upper surface of the base film by printing a metal material by any one printing method selected from inkjet, screen printing and gravure.

### [EFFECTS OF THE INVENTION]

According to one embodiment of the present invention, by forming a printed electronic circuit with a structure including a PCT film on at least one side, it is possible to prevent the phenomenon of film surface tearing or peeling under high temperature and high humidity conditions by preventing formation of oligomer due to moisture absorption. Consequently, it is possible to ensure long-term reliability. In addition, according to the embodiment of the present invention, it is possible to manufacture a variety of electrical devices such as interface products which have excellent quality compared with conventional products. In particular, it is possible to slim the device while ensuring long-term reliability by replacing various vehicular electrical devices which have been conventionally used, reduce processes and manufacturing time, reduce product costs, and provide the useful effect of an increase in product reliability.

### [BRIEF EXPLANATION OF THE DRAWINGS]

Fig. 1 is a schematic diagram for explaining a patterning formation method of a printing method formed on a film base according to an embodiment of the present invention;
Fig. 2 is a schematic diagram for explaining a patterning formation method of a printing method formed on a film base according to an embodiment of the present invention;
Fig. 3 is a schematic diagram for explaining a patterning formation method of a printing method formed on a film base according to an embodiment of the present invention;
Fig. 4 is a schematic diagram for explaining a patterning formation method of a printing method formed on a film base according to an embodiment of the present invention;
Fig. 5 is a schematic diagram for explaining a patterning formation method of a printing method formed on a film base according to an embodiment of the present invention;
Fig. 6 is a schematic diagram for explaining a patterning formation method of a printing method formed on a film base according to an embodiment of the present invention;
Fig. 7 is a schematic diagram for explaining a patterning formation method of a printing method formed on a film base according to an embodiment of the present invention;
Fig. 8 is a process flow-chart showing a manufacturing method of an electrical device using a patterning formation method of a printing method formed on a film base according to an embodiment of the present invention;
Fig. 9 is a diagram showing a vehicular LED module and shows an example of a vehicular electrical device using a patterning formation method of a printing method formed on a film base according to an embodiment of the present invention;
Fig. 10 is a diagram showing a vehicular metal mesh type touch module and shows an example of a vehicular electrical device according to an embodiment of the present invention;
Fig. 11 is a diagram showing a vehicular ITO type touch module and shows an example of a vehicular electrical device according to an embodiment of the present invention;
Fig. 12 is a diagram showing a vehicular FFC type bus bar cable and shows an example of a vehicular electrical device according to an embodiment of the present invention;
Fig. 13 is a diagram showing a vehicular FFC type bus bar cable and shows an example of a vehicular electrical device according to an embodiment of the present invention;
Fig. 14 is a diagram showing a vehicular FFC type bus bar cable and shows an example of a vehicular electrical device according to an embodiment of the present invention;
Fig. 15 is a diagram showing a vehicular rear camera FFC type hybrid flexible cable and shows an example of a vehicular electrical device according to an embodiment of the present invention;
Fig. 16 is a diagram showing a vehicular rear camera FFC type hybrid flexible cable and shows an example of a vehicular electrical device according to an embodiment of the present invention; and
Fig. 17 is a diagram showing a vehicular rear camera FFC type hybrid flexible cable and shows an example of a vehicular electrical device according to an embodiment of the present invention.

### [DESCRIPTION OF EMBODIMENTS]

One embodiment of the present invention is explained below while referring to the attached drawings. It should be possible to better understand the aims, structure and characteristics of the embodiment of the present invention through such a detailed explanation.

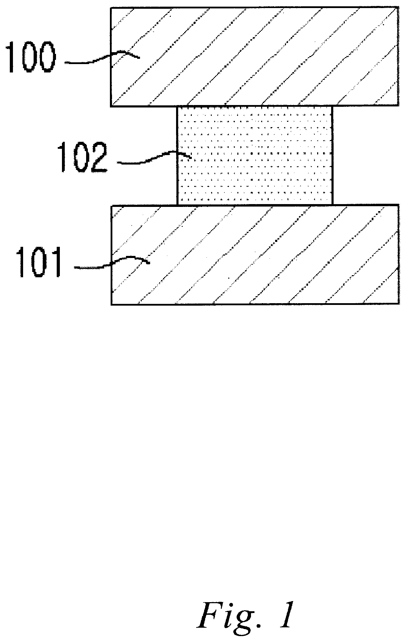

In the patterning formation method of a printing method formed on a film base according to an embodiment of the present invention, a PCT film formed by a PCT (Poly Cyclohexylene dimethylene terephthalate) material is used as a base film 101. A metal layer 102 including a metal material is formed on an upper surface of the PCT film by any one printing method selected from inkjet, screen printing and gravure as shown in Fig. 1. The PCT material is resistant to high temperature and high humidity conditions. That is, a heat resistance temperature of the PCT material is high and characteristics of the PCT material do not change due to moisture under high temperature and high humidity conditions.

In the embodiments, the metal material used as the metal layer 102 may be gold, silver, copper, platinum, carbon, nickel, indium or tin, or an alloy of two or more of these materials.

Here, silver may be the main metal material in the metal material. In some embodiments, the metal material may include an alloy of silver and copper.

Here, any one selected from a PCT film, PI film or PEN film may be used as a coverlay film 100 for protecting the metal layer 102.

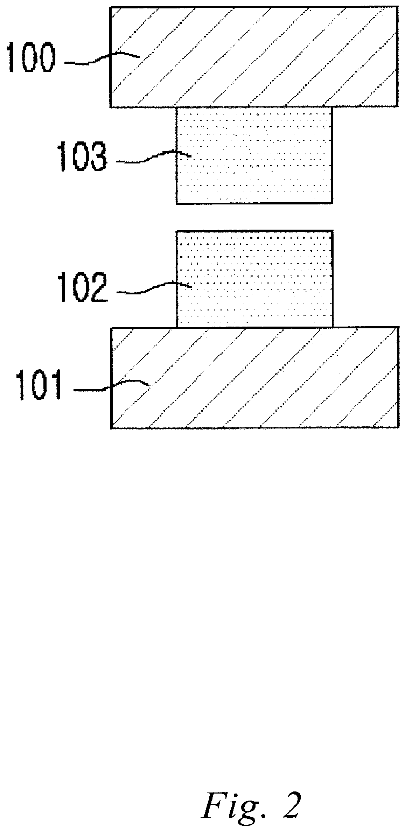

Here, it is possible to further form an insulating layer 103 between the metal layer 102 and the coverlay film 100 by printing an insulating material by any one printing method selected from inkjet, screen printing and gravure as is shown in Fig. 2.

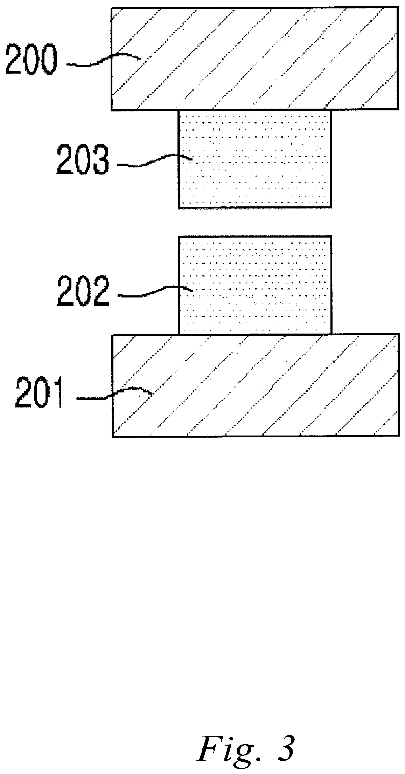

In addition, the patterning formation method of a printing method formed on a film base according to an embodiment of the present invention may form an insulating layer 202 by printing an insulating film material using any one printing method selected from inkjet, screen printing and gravure on an upper surface of a PCT film which is used as a base film 201 as shown in Fig. 3.

In the embodiments, the insulating film material may be any one selected from SiO₂, Si₃N₄, P₂O₅, B₂O₃, and silicone.

Here, it is possible to form a metal layer 203 by printing a metal material using any one printing method selected from inkjet, screen printing and gravure on an upper surface of the insulating layer 202.

Here, the device includes a coverlay film 202 for protecting the metal layer 203. Any one selected form a PCT film, PI film or PEN film may be used as the coverlay film 200.

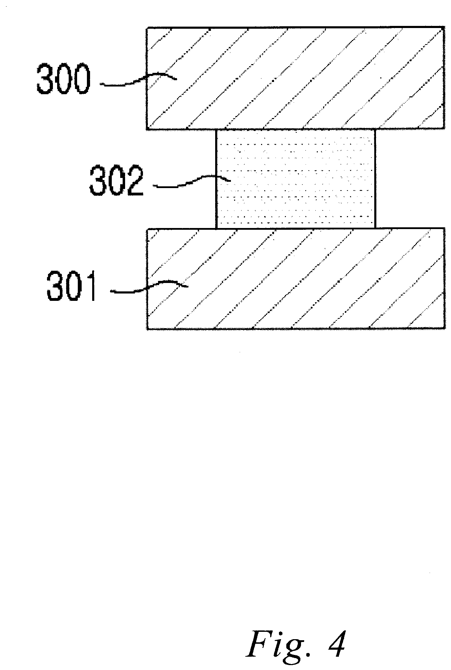

In addition, the patterning formation method of a printing method formed on a film base according to an embodiment of the present invention may form a semiconductor layer (active layer) 302 by printing a semiconductor material using any one printing method selected from inkjet, screen printing and gravure on an upper surface of a PCT film which is used as a base film 301 as shown in Fig. 4.

In the embodiments, the semiconductor material may include carbon, silicon, germanium, gallium or arsenic, or an alloy of two or more of these materials.

Here, the device includes a coverlay film 300 for protecting the semiconductor layer 302. Any one selected form a PCT film, PI film or PEN film may be used as the coverlay film 300.

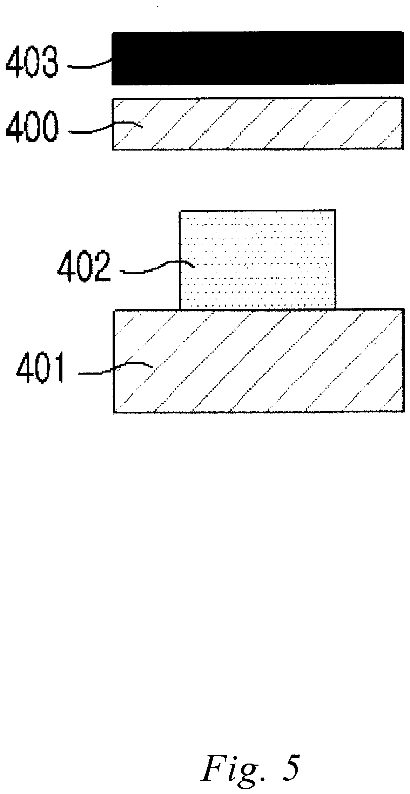

In addition, the patterning formation method of a printing method formed on a film base according to an embodiment of the present invention may include arranging a PI (Poly Imide) film or PEN (Poly Ethylene Napthalene) film on a lower part as a base film 401, arranging a PCT film on an upper part as the coverlay film 400, and forming a silk printing layer 403 by a silk printing method on an upper surface of the coverlay film 400 as is shown in Fig. 5.

In some embodiments, the silk printing layer 403 is formed in a pattern for use in arrangement of various electronic components.

Here, the device includes a metal layer 402 between the base film 401 and the coverlay film 400. The metal layer 402 is formed by printing a metal material by any one printing method selected from inkjet, screen printing and gravure.

Here, the metal layer 402 may be printed on an upper surface of the base film 401, the metal layer 402 may be printed on a lower surface of the coverlay film 400.

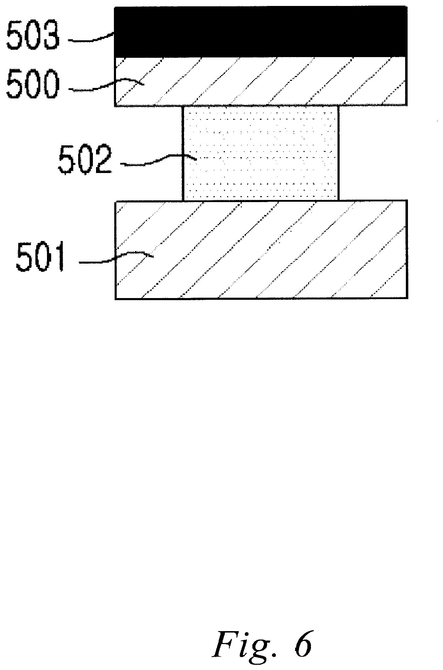

In addition, the patterning formation method of a printing method formed on a film base according to an embodiment of the present invention may include arranging a PCT film on a lower part as a base film 501, arranging a PCT film on an upper part as the coverlay film 500, and forming a silk printing layer 503 by a silk printing method on an upper surface of a PCT film as is shown in Fig. 6.

In the embodiments, the silk printing layer 503 is formed in a pattern for use in the arrangement of various electronic components.

Here, the device includes the metal layer 502 between the base film 501 and the coverlay film 500 is formed by printing a metal material using a printing method selected from any one of inkjet, screen printing and gravure.

Here, the metal layer 502 may be formed by printing on an upper surface of the base film 501, the metal layer 502 may be formed by printing on a lower surface of the coverlay film 500.

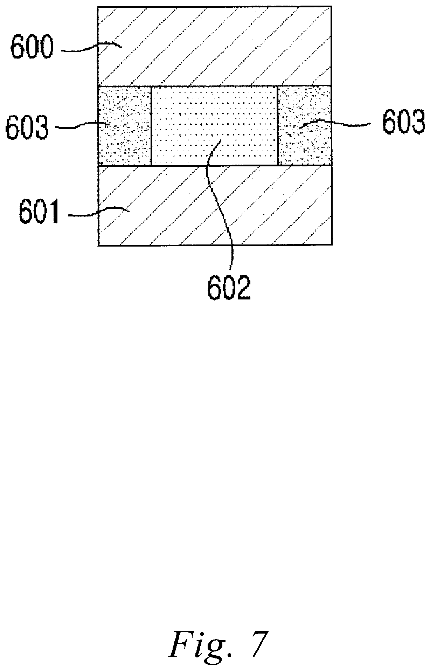

On the other hand, a manufacturing method of an electrical device according to an embodiment of the present invention is a method for manufacturing a device which is used as an electrical tool using the patterning formation method using a printing method and formed on the film base described above. As is shown in Fig. 7, the device is formed by forming a PCT film used as a base film 601, forming a pattern layer 602 by printing a metal material or a semiconductor material on an upper surface of the film by any one printing method selected from inkjet, screen printing and gravure, attaching a coverlay film 600 to an upper surface of the pattern layer 602 by integrally adhering the base film 601, the pattern layer 602 and the cover lay film 600 through an adhesive layer 603 comprising a thermosetting adhesive.

In the embodiments, a thermoplastic adhesive instead of a thermosetting adhesive may be used for the adhesive layer 603.

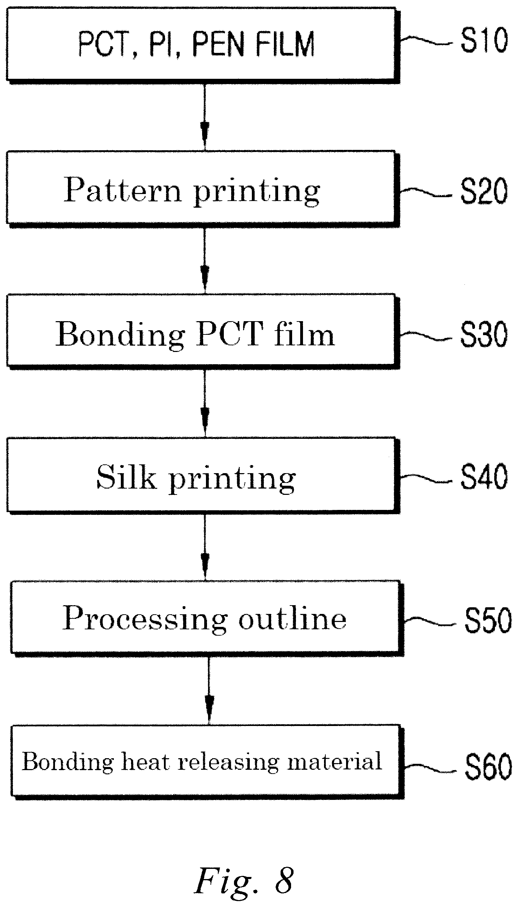

In addition, a manufacturing method of an electrical device according to an embodiment of the present invention is a method for manufacturing a device which is used as an electrical tool using the patterning formation method using a printing method and formed on the film base described above. As is shown in Fig. 8, the method includes a base film providing step (S10), a pattern printing step (S20), a coverlay film bonding step (S30), a silk printing step (S40), an outline processing step (S50), and a heat releasing material bonding step (S60) is a technique which can improve and replace the manufacturing method of conventional FPCB.

The base film providing step (S10) is a step for providing any one selected from a PI film, a PEN film and a PCT film as a base film.

The pattern printing step (S20) is a step for forming a pattern layer by printing a metal material or a semiconductor material on an upper surface of the base film by any one printing method selected from inkjet, screen printing and gravure.

The coverlay film bonding step (S30) is a step in which a PCT film is provided and bonded as a coverlay film so as to cover the pattern layer.

In the embodiments, the PI film or the PEN film is used as the coverlay film, the PCT film is used as either one of the base films and the coverlay film.

The silk printing step (S40) is a step for forming a silk printing layer by a silk printing method on an upper surface of the PCT film which is bonded by the coverlay film.

A surface treatment process may be performed on the resultant product after the silk printing step.

The outline processing step (S50) is a step for processing an outline on the product of the silk printing step (S40).

At this time, the outline processing is to process an outline by processing with a metal mold or a laser to forms an external shape.

The heat releasing material bonding step (S60) is a step for bonding a heat releasing sheet having a heat releasing function on a lower part of the product of the outline processing step.

In the embodiments, an aluminum plate is used as the heat releasing sheet for heat releasing efficiency.

On the other hand, although the instant specification describes the patterning formation method including printing on a film base in reference to vehicular electrical devices, one of ordinary skill in the art would understand that the method can be used to manufacture various other interface products.

A vehicular electrical device may be manufactured using the patterning formation method of a printing method formed on the film base described above with products. The vehicular electrical device connected to a vehicular lamp LED module, a vehicular metal mesh type touch module, a vehicular ITO type touch module, an FFC (Flexible Flat Cable) type bus bar cable, or an FFC type hybrid flexible cable for vehicular rear camera interfaces and the like.

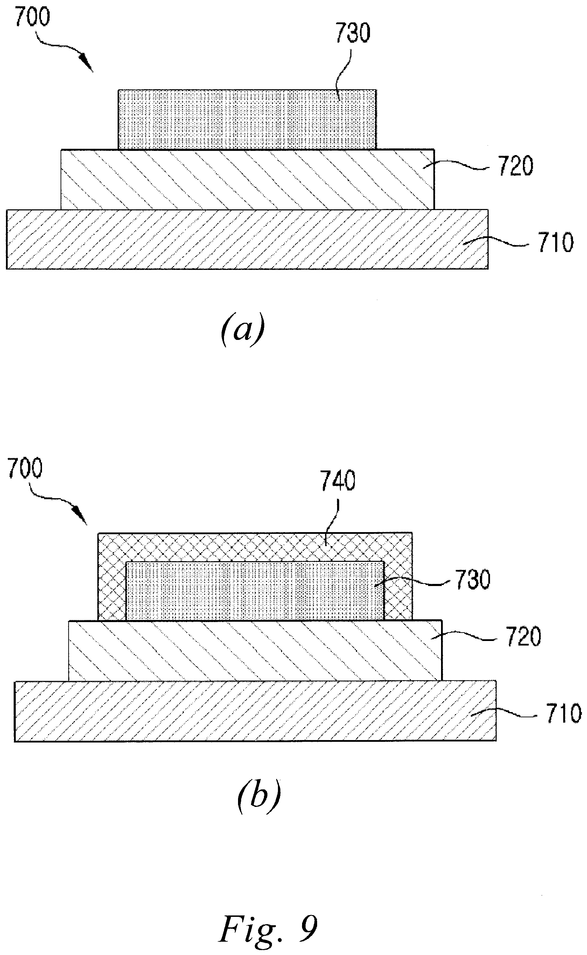

Fig. 9 is a diagram which shows a structure of a vehicular electrical device for use as a vehicular lamp LED module.

As is shown in Fig. 9, the vehicular electrical device is used as a vehicular lamp LED module 700. The vehicular lamp LED module 700 may include a heat releasing plate 710, an insulating layer 720 formed on an upper surface of the heat releasing plate by any one printing method selected from inkjet, screen printing and gravure, and a metal layer 730 pattern formed on an upper surface of the insulating layer by any one printing method selected from inkjet, screen printing and gravure.

In the embodiments, an insulating layer 740 may be further formed so as to cover the metal layer 730.

Here, the insulating layers 720 and 740 may be formed by printing a PCT (Poly cyclohexylene dimethyl terephthalate) material, or may be used in a form in which PCT films are bonded.

Here, the metal layer 730 is used for a purpose of mounting an LED which is a light source and supplying power to the LED.

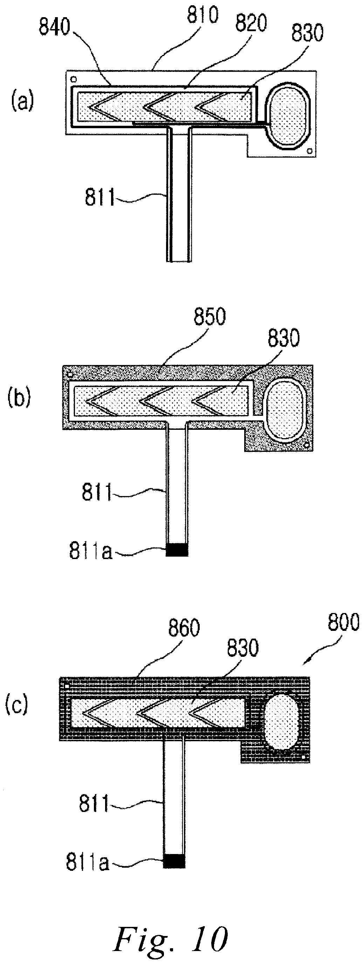

Fig. 10 is a diagram for explaining a structure of a vehicular electrical device in which a vehicular metal mesh type touch module is used.

As is shown in Fig. 10, the vehicular electrical device is used as a vehicular metal mesh type touch module 800. The vehicular electrical device may include a printing type touch film 810 which has a connector connection part 811, a PCT film 820 arranged on one surface of an upper part or a lower part of the printing type touch film, a touch recognition part 830 formed above the PCT film and formed in a mesh type pattern using a metal material by any one printing method selected from inkjet, screen printing and gravure, a touch outline part 840 connected to the touch recognition part and formed at the outermost edge of the touch recognition part by a metal printing method, a carbon printing part 850 formed by electrically connecting to the touch outline part, and an optical double-sided tape 860 which is arranged on one surface of the PCT film.

In the embodiments, the optical double-sided tape 860 may be formed by an autoclave or a UV processing method so as to adhere to an injected substance.

In the embodiments, a connector part 811a connecting to the touch outline part 840 is formed on the connector connection part 811 and at an end part of the connector connection part 811 so as to be capable of being directly connected to a driver IC, , and the connector part is formed by a carbon printing layer.

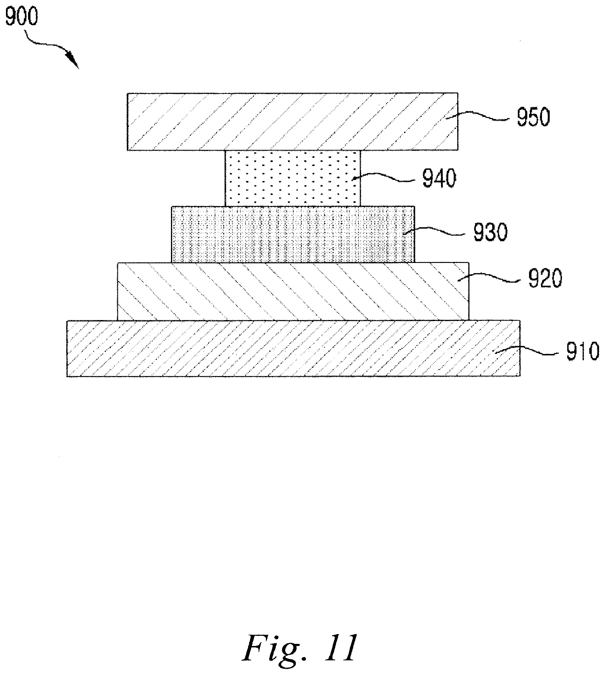

Fig. 11 is a diagram which shows a structure of a vehicular electrical device for use as a vehicular ITO type touch film module.

As is shown in Fig. 11, the vehicular electrical device is a vehicular ITO touch film module 900. The vehicular electrical device may have a structure which includes a PCT film 910 as a base, an ITO layer 920 formed on the upper surface of the PCT film by an ITO material by any one printing method selected from inkjet, screen printing and gravure, a printing layer 930 formed on an upper surface of the ITO layer by any one printing method selected from inkjet, screen printing and gravure, an optical double-sided tape 940 attached to the upper surface of the printing layer, and an adhesive tool 950 attached via the optical double-sided tape as a medium.

The printing layer 930 may include a metal layer, an insulating layer and a semiconductor layer.

In the embodiments, the printing layer 930 includes the metal layer, and the metal layer is arranged in one or more layers and has a function for supplying a current. The printing layer 930 includes the insulating layer, and the insulating layer is arranged in one or more layers and has an electrical insulating function. The insulating layer is interposed between two metal layers or between a metal layer and a semiconductor layer, thereby insulating the layers. The printing layer 930 includes the semiconductor layer, and the semiconductor layer functions as a semiconductor element, such as a diode or transistor.

The optical double-sided tape 940 functions to attach layers both sides thereof while maintaining light transmittance, or functions to attach an intervening part or film.

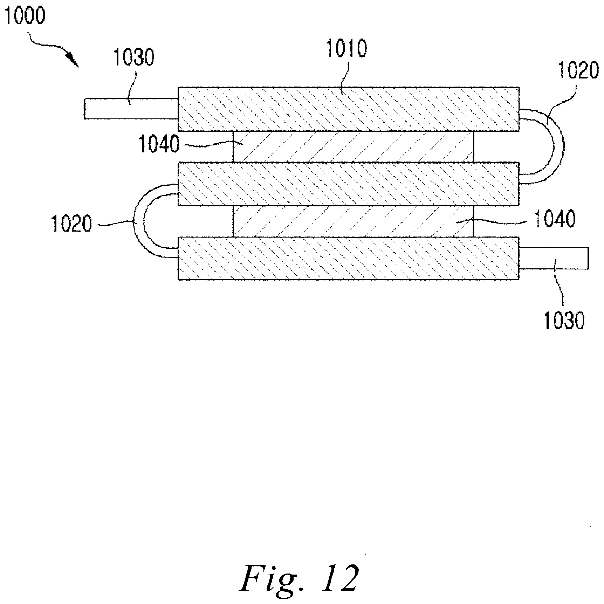

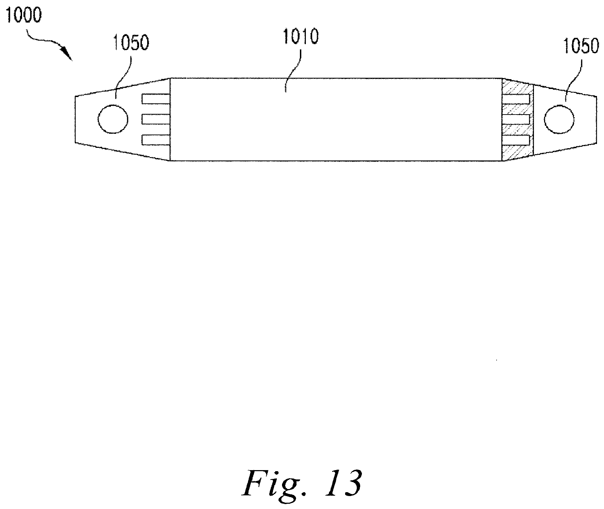

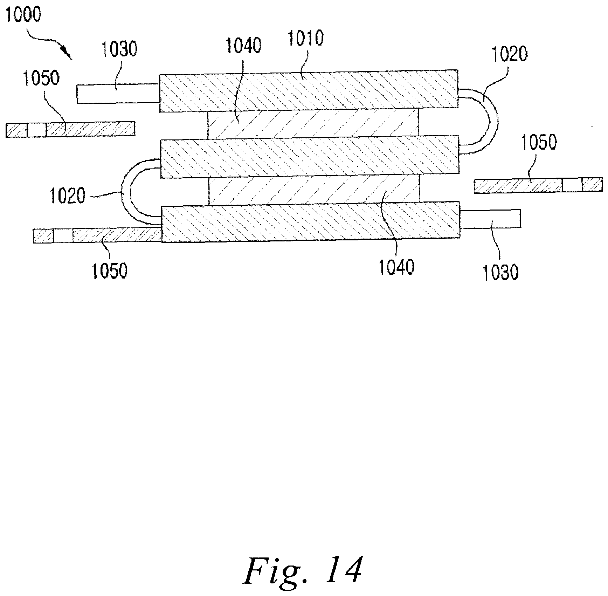

Fig. 12 to Fig. 14 are diagrams which show a structure of a vehicular electrical device for use as a vehicular FFC type bus bar cable.

As is shown in Fig. 12 to Fig. 14, the vehicular electrical device is used as a vehicular FFC type bus bar cable 1000. The vehicular electrical device may include an FFC (Flexible Flat Cable) type bus bar body 1010 formed from a PCT film, an FFC wire 1020 arranged inside the bus bar body, and a metal terminal 1030 arranged and exposed at both ends of the bus bar body and is connected to the FFC wire.

In the embodiments, the bus bar body 1010 is formed in multi-layers in which two or more PCT films having a constant length and width are stacked, and each layer is bonded together by an adhesive layer 1040.

Here, a metal plate 1050 which has a rivet hole on the side where the FFC wire 1020 is exposed is joined on the bus bar main body 1010 may be formed from a multi-layer including two or more PCT films. The metal plate 150 may be used to connect to other cables via a bolt to the rivet hole side.

In addition, the vehicular electrical device is used as a vehicular FFC type bus bar cable. The vehicular electrical device includes an FFC (Flexible Flat Cable) type bus bar body formed from a PCT film and a metal printing layer formed on the upper part of the FFC type bus bar body.

In the embodiments, the metal printing layer may be configured to function as any one of a passive element, an active element, a fuse element and a semiconductor element.

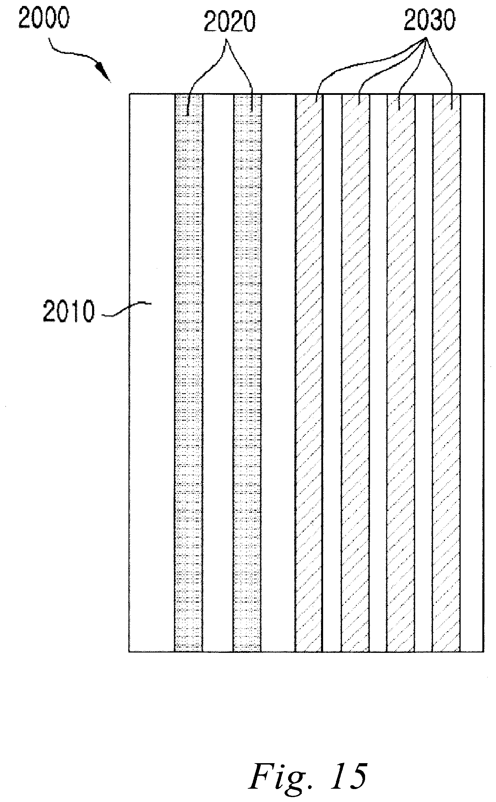

Fig. 15 to Fig. 17 show a vehicular electrical device used as a vehicular rear camera FFC type hybrid flexible cable.

As is shown in Fig. 15, the vehicular electrical device is used as a vehicle rear camera FFC type hybrid flexible cable 2000. The vehicular electrical device may include a PCT film 2010 arranged as a base, a metal ink printing line 2020 located on one side above one surface of the PCT film and is formed in a line shape in a longitudinal direction by printing a metal material by any one printing method selected from inkjet, screen printing and gravure, and an FFC wire line 2030 which is located on the other side of the one surface mentioned above of the PCT film and is formed in a line shape in a longitudinal direction arranged on the FFC wire.

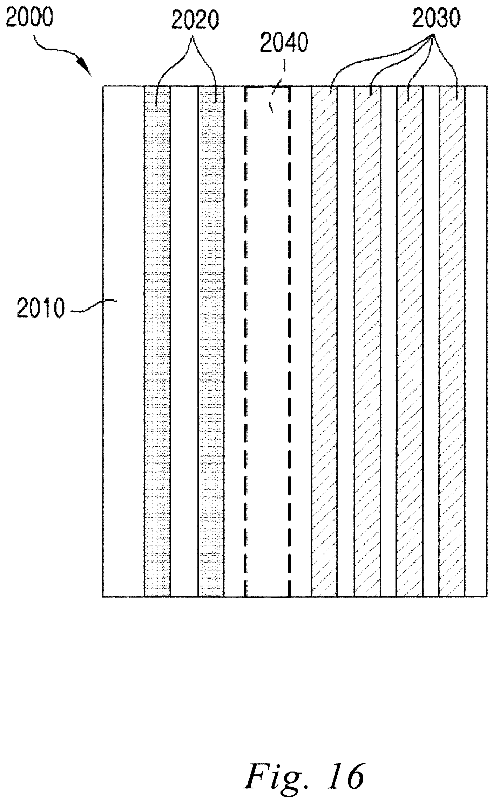

In the embodiments, a cross-talk prevention space 2040 for preventing cross-talk between the metal ink printing line 2020 and the FFC wire line 2030 may be formed as is shown in Fig. 16.

That is, it is preferred that each of the metal ink printing line 2020 and the FFC wire line 2030 are formed so as to be located on both side parts where the cross-talk prevention space 2040 is arranged.

Here, one or more metal ink printing lines 2020 according to necessity. The FFC wire line 2030 is arranged with an FFC type wire, and adhered on the PCT film via an adhesive so as to be arranged in a necessary number.

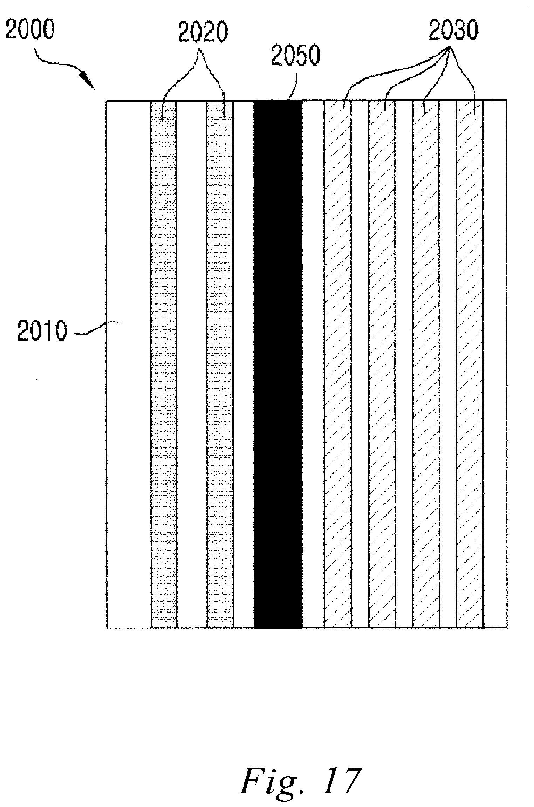

In addition, as is shown in Fig. 17, a cross-talk prevention dummy line 2050 between the metal ink printing line 2020 and the FFC wire line 2030 to prevent signal cross-talk therebetween.

At this time, the cross-talk prevention dummy line 2050 may be formed by any one printing method selected from inkjet, screen printing and gravure.

Here, the cross-talk prevention dummy line 2050 may include a metal layer including a metal material or a semiconductor layer including a semiconductor material.

In this way, in one embodiment of the present invention, it is possible to prevent the generation of oligomers by moisture absorption by using a structure which includes a printed electronic circuit on at least one side of a PCT film using the patterning formation method of a printing method formed on a film base, prevent the surface of a film from tearing or peeling off under high temperature and high humidity conditions and ensure long-term reliability. In addition, according to one embodiment of the present invention, it is possible to manufacture a variety of electrical devices such as interface products which have excellent quality compared with conventional products. In particular, it is possible to slim the device while ensuring long-term reliability by replacing various vehicular electrical devices which have been conventionally used, reduce processes and manufacturing time, and in addition to reduce product costs. Further, it is possible to exhibit the advantage of an increase in product reliability.

The embodiment explained above is merely an explanation of a preferred embodiment of the present invention and the present invention is not limited to such an embodiment. Various corrections and modifications can be made by a person skilled in the art within the technical idea of the present invention and the scope of the claims. This can be said to belong to the technical scope of the present invention.

### [EXPLANATION OF REFERENCE SYMBOLS]

101: Base film (PCT film)
102: Metal layer
202: Insulating layer
302: Semiconductor layer
403: Silk printing layer

### (Appendix)

Furthermore, the present invention can be understood as following configurations, for example.
(configuration 1) A vehicular electrical device for use as a vehicular LED module including:
   a heat sink; and
   a metal layer formed on an upper side of the heat sink by any one printing method selected from inkjet, screen printing and gravure.
(configuration 2) The vehicular electrical device according to configuration 1, further including:
   an insulating layer formed to cover the metal layer.
(configuration 3) The vehicular electrical device according to configuration 2, wherein the insulating layer is made of a PCT (Poly Cyclohexylene dimethylene terephthalate) material.
(configuration 4) A vehicular electrical device for use as a vehicular touch module including:
   a printing type touch film having a connector connection part;
   a PCT film arranged on one surface of an upper part or lower part of the printing type touch film;
   a touch recognition part formed in a mesh type pattern on the PCT film and formed using a metal material by any one printing method selected from inkjet, screen printing and gravure printing methods;
   a touch outline part connected to the touch recognition part and formed at an edge part of the touch recognition part by a metal printing method;
   a carbon printing part formed by being electrically connected to the touch outline part; and
   an optical double-sided tape arranged on one side of the PCT film;
   wherein
   the optical double-sided tape is formed by an autoclave or UV processing method so as to be adhered to an injection object.
(configuration 5) The vehicular electrical device according to configuration 4, wherein the touch recognition part formed in the mesh type pattern is formed having a line width of 40 µm or less.
(configuration 6) The vehicular electrical device according to configuration 5, wherein the touch recognition part is formed by performing an offset method etching process in order to form the mesh pattern of the touch recognition part having a line width of 40 µm or less.
(configuration 7) A vehicular electrical device for use as a vehicular touch module including:
   a PCT film;
   an ITO layer formed from an ITO material on an upper surface of the PCT film by any one printing method selected from inkjet, screen printing and gravure;
   a printing layer formed on an upper surface of the ITO layer by any one printing method selected from inkjet, screen printing and gravure;
   an optical double-sided tape adhered to an upper surface of the printing layer; and
   an adhesive tool adhered through the optical double-sided tape as a medium.
(configuration 8) A vehicular electrical device for use as a vehicular bus bar cable including:
   an FFC (Flexible Flat Cable) type bus bar body formed from a PCT film;
   an FFC wire within the bus bar body; and
   a metal terminal connected to the FFC wire and exposed at both ends of the bus bar body.
(configuration 9) The vehicular electrical device according to configuration 8, wherein the bus bar body is formed from a multi-layer in which two or more PCT films having a constant length and width are stacked, and each layer is bonded by an adhesive layer.
(configuration 10) The vehicular electrical device according to configuration 9, further including a metal plate having a rivet hole on a side where the FFC wire is exposed, the metal plate being joined on the bus bar body formed from a multi-layer including the two or more PCT films wherein the metal plate is connected to another cable by bolting to the rivet hole side.
(configuration 11) The vehicular electrical device according to configuration 8, wherein a thickness of the FFC wire ranges from 30 µm to 100 µm.
(configuration 12) A vehicular electrical device for use as a vehicular bus bar cable including:
   an FFC (Flexible Flat Cable) type bus bar body formed from a PCT film; and
   a metal printing layer formed on an upper part of the FFC type bus bar body;
   wherein
   the metal printing layer has a function of any one of a passive element, an active element, a fuse element and a semiconductor element.
(configuration 13) A vehicular electrical device for use as a vehicular hybrid flexible cable including:
   a PCT film;
   a metal ink printing line formed in a line shape in a longitudinal direction, located on one surface of the PCT film and formed by printing a metal material by any one printing method selected from inkjet, screen printing and gravure; and
   an FFC wire line formed in a line shape in a longitudinal direction, located on another surface of the PCT film and including an FCC wire.
(configuration 14) The vehicular electrical device according to configuration 13,
   further including a crosstalk prevention space for preventing signal crosstalk between the metal ink printing line and the FFC wire line arranged between the metal ink printing line and the FFC wire line,
   wherein the metal ink printing line and the FFC wire line are formed so as to be positioned on both sides of the crosstalk prevention space.
(configuration 15) The vehicular electrical device according to configuration 13,
   further including a crosstalk prevention dummy line for preventing signal crosstalk between the metal ink printing line and the FFC wire line arranged between the metal ink printing line and the FFC wire line.
(configuration 16) The vehicular electrical device according to configuration 15, wherein the crosstalk prevention dummy line is formed by any one group of printing methods selected from inkjet, screen printing, and gravure.
(configuration 17) The vehicular electrical device according to configuration 15, wherein the crosstalk prevention dummy line is a metal layer or a semiconductor layer.
(configuration 18) A manufacturing method of a vehicular electrical device including:
   forming a pattern layer on an upper surface of a PCT film used as a base film by printing a metal material or a semiconductor material by any one printing method selected from inkjet, screen printing, and gravure;
   adhering a coverlay film to the upper surface of the pattern layer by integrally bonding the base film, the pattern layer and the coverlay film with an adhesive layer including a thermosetting adhesive as a medium.
(configuration 19) A manufacturing method of a vehicular electrical device including:
   forming a pattern layer on an upper surface of a PCT film used as a base film by printing a metal material or a semiconductor material by any one printing method selected from inkjet, screen printing, and gravure;
   adhering a coverlay film to the upper surface of the pattern layer; and
   integrally bonding the base film, the pattern layer and the coverlay film with an adhesive layer including a thermoplastic adhesive as a medium.
(configuration 20) A manufacturing method of an electrical device including:
   (A) a step of arranging any one film selected from a PI film, a PEN film and a PCT film as a base film;
   (B) a step of forming a pattern layer on an upper surface of the base film by printing a metal material or a semiconductor material by any one printing method selected from inkjet, screen printing and gravure;
   (C) a step of arranging and bonding together a PCT film as a coverlay film so as to cover the pattern layer;
   (D) a step of forming a silk printing layer on the upper surface of the PCT film bonded as the coverlay film by a silk printing method;
   (E) a step of forming an outline shape by processing an outline with a mold or laser processing on the resultant product after the step (D); and
   (F) a step of bonding an aluminum plate for a heat releasing function to a lower part of the resultant product after the step (E).
(configuration 21) A patterning formation method of a printing method formed on a film base including:
   forming a metal layer on an upper surface of a PCT film used as a base film by printing a metal material by any one printing method selected from inkjet, screen printing and gravure.
(configuration 22) The patterning formation method of a printing method formed on the film base according to configuration 21, wherein the metal material is any one selected from gold, silver, copper, platinum, carbon, nickel, indium and tin or a mixed alloy of two or more selected from gold, silver, copper, platinum, carbon, nickel, indium and tin.
(configuration 23) A patterning formation method of a printing method formed on a film base including:
   forming an insulation layer on an upper surface of a PCT film used as a base film by printing an insulating material by any one printing method selected from inkjet, screen printing and gravure.
(configuration 24) The patterning formation method of a printing method formed on the film base according to configuration 23, wherein the insulating film material is any one selected from SiO₂, Si₃N₄, P₂O₅, B₂O₃, and silicone.
(configuration 25) A patterning formation method of a printing method formed on a film base including:
   forming a semiconductor layer (active layer) on an upper surface of a PCT film used as a base film by printing a semiconductor material by any one printing method selected from inkjet, screen printing and gravure.
(configuration 26) The patterning formation method of a printing method formed on the film base according to configuration 25, wherein the semiconductor material is any one selected from carbon, silicon, germanium, gallium and arsenic or a mixed compound of two or more selected from carbon, silicon, germanium, gallium and arsenic.
(configuration 27) A patterning formation method of a printing method formed on a film base including:
   arranging a PI (Poly Imide) film or a PEN (Poly Ethylene Napthalene) film as a base film on a lower part,
   arranging a PCT film as a coverlay film on an upper part; and
   forming a silk printing layer on an upper surface of the PCT film by a silk printing method so as to use the silk printing layer in the arrangement of electronic components.
(configuration 28) A patterning formation method of a printing method formed on a film base including:
   arranging a PCT film as a base film on a lower part;
   arranging a PCT film as a coverlay film on an upper part; and
   forming a silk printing layer on an upper surface of the PCT film used as the coverlay film by a silk printing method so as to use the silk printing layer in the arrangement of electronic components.
(configuration 29) The patterning formation method of the printing method formed on the film base according to configuration 27 or configuration 28, further including forming a metal layer on the upper surface of the base film by printing a metal material by any one printing method selected from inkjet, screen printing and gravure.

## Claims

1. A vehicular electrical device for use as a vehicular bus bar cable comprising:
an FFC (Flexible Flat Cable) type bus bar body formed from a PCT film;
an FFC wire within the bus bar body; and
a metal terminal connected to the FFC wire and exposed at both ends of the bus bar body.

2. The vehicular electrical device according to claim 1, wherein the bus bar body is formed from a multi-layer in which two or more PCT films having a constant length and width are stacked, and each layer is bonded by an adhesive layer.

3. The vehicular electrical device according to claim 2, further comprising a metal plate having a rivet hole on a side where the FFC wire is exposed, the metal plate being joined on the bus bar body formed from a multi-layer including the two or more PCT films wherein the metal plate is connected to another cable by bolting to the rivet hole side.

4. The vehicular electrical device according to claim 1, wherein a thickness of the FFC wire ranges from 30 µm to 100 µm.
